(19) Europäisches Patentamt
European Patent Office
Office européen des brevets

(11) EP 3 531 206 A1

(12) EUROPEAN PATENT APPLICATION

(43) Date of publication:
28.08.2019 Bulletin 2019/35

(51) Int Cl.:
G03F 7/20 (2006.01)

(21) Application number: 18158448.3

(22) Date of filing: 23.02.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(71) Applicant: ASML Netherlands B.V.
5500 AH Veldhoven (NL)

(72) Inventor: KOOIMAN, Marleen
5500 AH Veldhoven (NL)

(74) Representative: Peters, John Antoine
ASML Netherlands BV
Corporate Intellectual Property
P.O. Box 324
5500 AH Veldhoven (NL)

(54) SYSTEMS AND METHODS FOR IMPROVING RESIST MODEL PREDICTIONS

(57) A method, involving computing a first intensity of a first aerial image and a second intensity of a second aerial image, the first aerial image corresponding to a first location within a resist layer and the second aerial image corresponding to a second location within the resist layer. The method further involves, performing, by a hardware computer system using a resist model, a computer simulation of the resist layer to obtain a value of a parameter for a resist layer feature based on a difference between the first and second intensities or on a difference between a resist model result for the first intensity and a resist model result for the second intensity.

~-0.02    ~0    ~0.03    ~0.06    ~0.08    ~0.11

Vertical Intensity Range

Fig. 5

**Description**

TECHNICAL FIELD

The description herein relates to systems and methods for improving predictions of resist contours made by resist models.

BACKGROUND

A lithographic apparatus can be used, for example, in the manufacture of integrated circuits (ICs) or other devices. In such a case, a patterning device (e.g., a mask) may contain or provide a pattern corresponding to an individual layer of the device ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic apparatus, one target portion at a time. In one type of lithographic apparatus, the pattern on the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic apparatus will have a magnification factor M (generally < 1), the speed F at which the substrate is moved will be a factor M times that at which the projection beam scans the patterning device.

Prior to the device fabrication procedure of transferring the pattern from the patterning device to the substrate of the device manufacturing process, the substrate may undergo various device fabrication procedures of the device manufacturing process, such as priming, resist coating and a soft bake. After pattern transfer, the substrate may be subjected to other device fabrication procedures of the device manufacturing process, such as a post-exposure bake (PEB), development, a hard bake and measurement/inspection of the transferred pattern. This array of device fabrication procedures is used as a basis to make an individual layer of a device, e.g., an IC. The substrate may then undergo various device fabrication procedures of the device manufacturing process such as etching, ion-implantation (doping), metallization, oxidation, chemo-mechanical polishing, metrology (e.g., using a scanning electronic microscope (SEM)), etc., all intended to finish off the individual layer of the device. If several layers are required in the device, then the whole process, or a variant thereof, is repeated for each layer. Eventually, a device will be present in each target portion on the substrate. If there is a plurality of devices, these devices are then separated from one another by a technique such as dicing or sawing, whence the individual devices can be mounted on a carrier, connected to pins, etc.

So, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical or nanoimprint lithography using a lithographic apparatus, to provide a pattern on a substrate and typically, but optionally, involves one or more related pattern processing steps, such as resist development by a development apparatus, baking of the substrate using a bake tool, etching using the pattern using an etch apparatus, etc. Further, one or more metrology processes are typically involved in the patterning process.

As semiconductor manufacturing processes continue to advance, the dimensions of functional elements have continually been reduced while the amount of functional elements, such as transistors, per device has been steadily increasing over decades, following a trend commonly referred to as "Moore's law". At the current state of technology, layers of devices are manufactured using lithographic projection apparatuses that project a pattern corresponding to a design layout onto a substrate using illumination from a deep-ultraviolet illumination source, creating individual functional elements having dimensions well below 100 nm, i.e. less than half the wavelength of the radiation from the illumination source (e.g., a 193 nm illumination source). This process in which features with dimensions smaller than the classical resolution limit of a lithographic projection apparatus are printed, is commonly known as low-ki lithography, according to the resolution formula $CD = k_1 \times \lambda/NA$, where $\lambda$ is the wavelength of radiation employed (currently in most cases 248 nm or 193 nm), NA is the numerical aperture of projection optics in the lithographic projection apparatus, CD is the "critical dimension"- generally the smallest feature size printed - and $k_1$ is an empirical resolution factor. In general, the smaller $k_1$ the more difficult it becomes to reproduce a pattern on the substrate that resembles the shape and dimensions planned by a circuit designer in order to achieve particular electrical functionality and performance. To overcome these difficulties, sophisticated fine-tuning steps are applied to the lithographic projection apparatus and/or a pattern corresponding to a design layout. These include, for example, but not limited to, optimization of NA and/or optical coherence settings, customized illumination schemes, use of phase shifting patterning devices, optical proximity correction (OPC) in the pattern corresponding to the design layout (such as biasing of pattern feature, addition of an assist feature, applying a serif to a pattern feature, etc.), or other methods generally defined as "resolution enhancement techniques" (RET).

In lithographic applications, a resist model (e.g., Tachyon resist model) is frequently used to predict a resist contour of a profile as would be measured by a SEM apparatus. The resist model is introduced in order to correct for resist biases with respect to the resist contour predicted by a single aerial image. Specifically, either an aerial image at a suitable height within the resist thickness, or an average intensity of aerial images over the resist thickness is used for prediction purposes. Such a resist model is unable to accurately predict effects of focus dependent features, such as 1D line-space patterns in negative tone developed (NTD) resists with sub-resolution assist features (SRAFs) close to the main feature.

BRIEF SUMMARY

To enable understanding of how a patterning process works, computational lithography techniques can be used to simulate how one or more aspects of the patterning process "work." Thus, appropriate computational lithography software can predict one or more characteristics of the formation of a pattern on a substrate, such as a predicted CD, predicted contour, etc. of the pattern, and possibly do so at different stages of the formation of the pattern.

One aspect of such computational lithography is the prediction of the pattern in the resist layer. But, it has been discovered that existing techniques to predict the formation of the pattern in the resist layer may not adequately and/or quickly assess a pattern that can occur in the resist layer. Accordingly, it is desired, for example, to provide a technique that accurately and/or quickly predicts the expected (often highly complex) shapes of a resist pattern So, there is provided, for example, a method and system to improve resist model predictions of the resist layer. Specifically, the present disclosure describes a method for reducing modeling errors, for focus dependent features, by introducing a change of aerial image over the resist thickness as an additional variable in the resist model.

In an embodiment, there is provided a method comprising: computing a first intensity of a first aerial image and a second intensity of a second aerial image, the first aerial image corresponding to a first location within a resist layer and the second aerial image corresponding to a second location within the resist layer; and performing, by a hardware computer system using a resist model, a computer simulation of the resist layer to obtain a value of a parameter for a resist layer feature based on a difference between the first and second intensities or on a difference between a resist model result for the first intensity and a resist model result for the second intensity.

In an embodiment, there is provided a device including a processor. The processor is configured compute a first intensity of a first aerial image and a second intensity of a second aerial image, the first aerial image corresponding to a first location within a resist layer and the second aerial image corresponding to a second location within the resist layer; and perform a computer simulation of the resist layer to obtain a value of a parameter for a resist layer feature based on a difference between the first and second intensities or on a difference between a resist model result for the first intensity and a resist model result for the second intensity.

In an embodiment, there is provided a non-transitory computer program product comprising machine-readable instructions for causing a processor to cause performance of a method as described herein. In an embodiment, there is provided a system, comprising a hardware processor; and a non-transitory computer program product as described herein.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Fig. 1 is a block diagram of various subsystems of a lithography system.
Fig. 2 is a block diagram of simulation models of a computational lithography technique.
Fig. 3A, Fig. 3B, Fig. 3C and Fig. 3D schematically show exemplary deformation of a resist layer on a substrate.
Fig. 4A, Fig. 4B, Fig. 4C and Fig. 4D schematically show exemplary additional deformation caused by development of the resist layer.
Fig. 5.illustrates exemplary graphs depicting effect of vertical intensity range of feature shape for features having similar image log slope.
Figs. 6A and 6B depict according to an embodiment, a schematic illustrating effect of the vertical intensity range on feature shape.

Fig. 7 depicts an exemplary flowchart illustrating steps performed to improve resist model errors.
Fig. 8 is a block diagram of an example computer system.
Fig. 9 is a schematic diagram of a lithography projection apparatus.
Fig. 10 is a schematic diagram of another lithography projection apparatus.
Fig. 11 is a more detailed view of the apparatus of Fig. 11.
Fig. 12 is a more detailed view of the source collector module of the apparatus of Fig. 10 and Fig. 11.

DETAILED DESCRIPTION

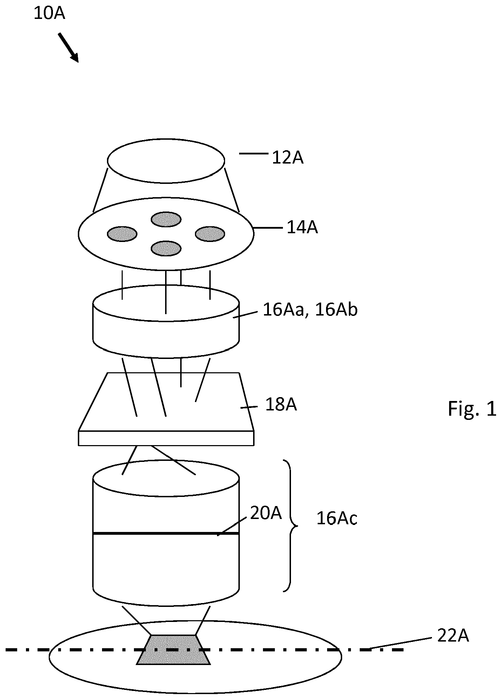

As background to embodiments and turning to Fig. 1, there is illustrated an exemplary lithographic projection apparatus 10A. Major components are a radiation source 12A, which may be a deep-ultraviolet excimer laser source or other type of source including an extreme ultra violet (EUV) source, illumination optics which define the partial coherence (denoted as sigma) and which may include optics 14A, 16Aa and 16Ab that shape radiation from the source 12A; a support configured to hold a patterning device 18A; and projection optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics $NA=\sin(\Theta_{max})$. In an embodiment, the lithographic projection apparatus itself need not have the radiation source 12A.

So, in a lithographic projection apparatus, the optics 16Ac directs an aerial image of the patterning device pattern onto the substrate (typically a de-magnified version). An aerial image (AI) is the radiation intensity distribution at substrate level. A resist layer on the substrate is exposed and the aerial image is transferred to the resist layer as a latent "resist image" (RI) therein. The resist image (RI) can be defined as a spatial distribution of solubility of the resist in the resist layer.

Now, it is often desirable to be able computationally determine how a patterning process would produce a desired pattern on a substrate. Thus, a simulation can be provided to simulate one or more parts of the process. For example, it is desirable to be able to simulate the lithography process of transferring the patterning device pattern onto a resist layer of a substrate as well as the yielded pattern in that resist layer after development of the resist.

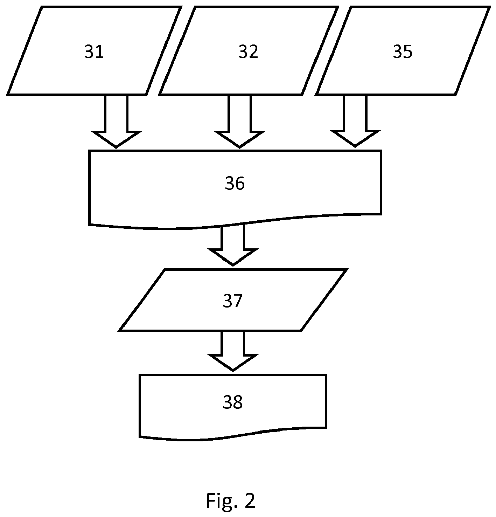

An exemplary flow chart for simulating lithography in a lithographic projection apparatus is illustrated in Fig. 2. An illumination model 31 represents optical characteristics (including radiation intensity distribution and/or phase distribution) of the illumination. A projection optics model 32 represents optical characteristics (including changes to the radiation intensity distribution and/or the phase distribution caused by the projection optics) of the projection optics. A design layout model 35 represents optical characteristics (including changes to the radiation intensity distribution and/or the phase distribution caused by a given design layout) of a design layout, which is the representation of an arrangement of features on or formed by a patterning device. An aerial image 36 can be simulated using the illumination model 31, the projection optics model 32 and the design layout model 35. A resist image 38 can be simulated from the aerial image 36 using a resist model 37. Simulation of lithography can, for example, predict contours and/or CDs in the resist image.

More specifically, it is noted that the illumination model 31 can represent the optical characteristics of the illumination that include, but not limited to, NA-sigma ($\sigma$) settings as well as any particular illumination shape (e.g. off-axis illumination such as annular, quadrupole, dipole, etc.). The projection optics model 32 can represent the optical characteristics of the of the projection optics, include, for example, aberration, distortion, a refractive index, a physical size or dimension, etc. The design layout model 35 can also represent one or more physical properties of a physical patterning device, as described, for example, in U.S. Patent No. 7,587,704, which is incorporated by reference in its entirety. Optical properties associated with the lithographic projection apparatus (e.g., properties of the illumination, the patterning device and the projection optics) dictate the aerial image. Since the patterning device used in the lithographic projection apparatus can be changed, it is desirable to separate the optical properties of the patterning device from the optical properties of the rest of the lithographic projection apparatus including at least the illumination and the projection optics, and hence design layout model 35.

The resist model 37 can be used to calculate the resist image from the aerial image, an example of which can be found in U.S. Patent No. 8,200,468, which is hereby incorporated by reference in its entirety. The resist model is typically related only to properties of the resist layer (e.g., effects of chemical processes which occur during exposure, post-exposure bake and/or development).

The objective of the simulation is to accurately predict, for example, edge placements, aerial image intensity slopes and/or CDs, which can then be compared against an intended design. The intended design is generally defined as a pre-OPC design layout which can be provided in a standardized digital file format such as GDSII, OASIS or other file format.

From the design layout, one or more portions may be identified, which are referred to as "clips". In an embodiment, a set of clips is extracted, which represents the complicated patterns in the design layout (typically about 50 to 1000 clips, although any number of clips may be used). As will be appreciated by those skilled in the art, these patterns or clips represent small portions (e.g., circuits, cells, etc.) of the design and especially the clips represent small portions for which particular attention and/or verification is needed. In other words, clips may be the portions of the design layout or may be similar or have a similar behavior of portions of the design layout where critical features are identified either by experience (including clips provided by a customer), by trial and error, or by running a full-chip simulation. Clips often contain one or more test patterns or gauge patterns. An initial larger set of clips may be provided a priori by a customer based on known critical feature areas in a design layout which require particular image optimization. Alternatively, in another embodiment, the initial larger set of clips may be extracted from the entire design layout by using some kind of automated (such as, machine vision) or manual algorithm that identifies the critical feature areas.

In some examples, the simulation and modeling can be used to configure one or more features of the patterning device pattern (e.g., performing optical proximity correction), one or more features of the illumination (e.g., changing one or more characteristics of a spatial / angular intensity distribution of the illumination, such as change a shape), and/or one or more features of the projection optics (e.g., numerical aperture, etc.). Such configuration can be generally referred to as, respectively, mask optimization, source optimization and projection optimization. Such optimizations can be performed on their own or combined in different combinations. One such example is source-mask optimization (SMO) involves the configuring of one or more features of the patterning device pattern together with one or more features of the illumination. The optimization techniques may focus on one or more of the clips. The optimizations may use the simulations described herein to produce values of various parameters.

In an optimization process of a system, a figure of merit of the system can be represented as a cost function. The optimization process boils down to a process of finding a set of parameters (design variables) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics; the cost function can also be the maximum of these deviations (i.e., worst deviation). The term "evaluation points" herein should be interpreted broadly to include any characteristics of the system. The design variables of the system can be confined to finite ranges and/or be interdependent due to practicalities of implementations of the system. In case of a lithographic projection apparatus, the constraints are often associated with physical properties and characteristics of the hardware such as tunable ranges, and/or patterning device manufacturability design rules and the evaluation points can include physical points on a resist image on a substrate, as well as non-physical characteristics such as dose and focus.

As noted above, a layer on a substrate can have a pattern transferred thereto. Such a layer will be generally referred to as a resist layer and may have various chemical compositions. In an embodiment, the resist layer is a layer of radiation-sensitive material. The resist layer usually has a small but finite thickness that may be comparable in size to patterns imaged onto the resist. The resist layer may undergo various treatments in a lithographic process. For example, the resist may be exposed to radiation such as EUV or DUV, which induces chemical reactions in the resist. The resist may undergo a post-exposure bake (PEB), development (e.g., positive tone development or negative tone development), and/or a hard bake. Each of these treatments may cause the resist to deform in one, two or three dimensions and the deformation may be location dependent (e.g., three-dimensional location dependent). The deformation of the resist may affect downstream treatments such as material deposition and etching. In a lithographic process using negative tone development, the impact of the resist deformation on resist top loss and critical dimension may be especially significant. Therefore, a resist model 37 with the ability to predict deformation of the resist is beneficial to more accurate lithography and higher yield. The resist model 37 may also be able to predict the reaction of the resist layer to various other physical and chemical treatments in the lithographic process. An exemplary resist model according to an aspect of the present disclosure is described later.

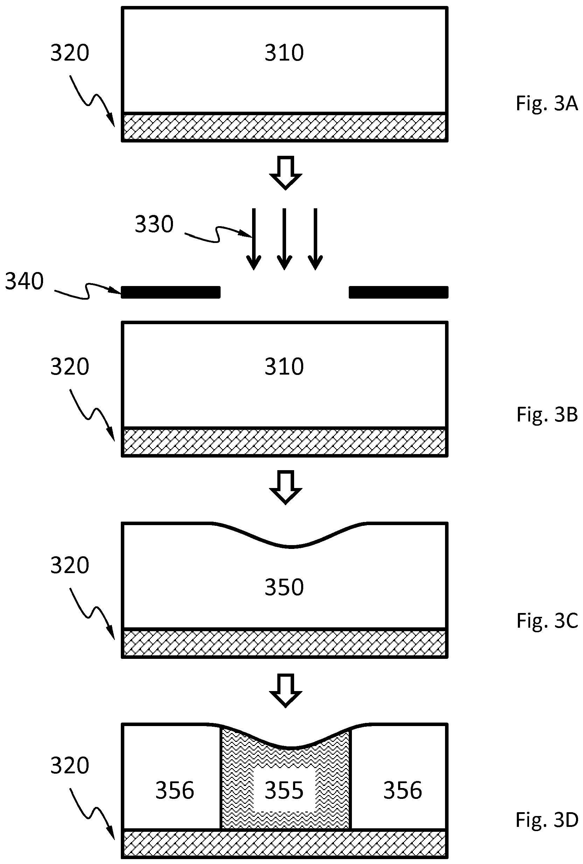

Fig. 3A, Fig. 3B, Fig. 3C and Fig. 3D schematically show exemplary deformation of a resist layer 310 on a substrate 320. A pattern is formed in the resist layer, e.g., by exposing the resist layer 310 to radiation 330 via a patterning device 340. The resist layer 310 may undergo post-exposure treatments such as PEB and deform into a deformed resist layer 350. In this example, the deformation of the resist layer 310 is such that the portion of the deformed resist layer 350 exposed to the radiation has a smaller thickness than the rest of the deformed resist layer 350. A portion 355 of the deformed resist layer 350 received sufficiently high dose during the exposure to remain on the substrate 320 after negative tone development and the rest (e.g., portions 356) of the deformed resist layer 350 is dissolved after negative tone development. Alternatively, the portion 355 of the deformed resist layer 350 received sufficiently high dose during the exposure to dissolve during positive tone development and the rest of the deformed resist layer 350 remains on the substrate 320 after positive tone development. Whether the portion 355 remains or dissolves depends on the chemical composition of the resist and the chemical composition of the developer.

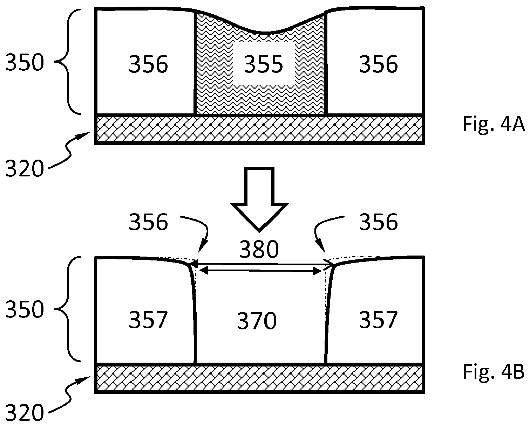

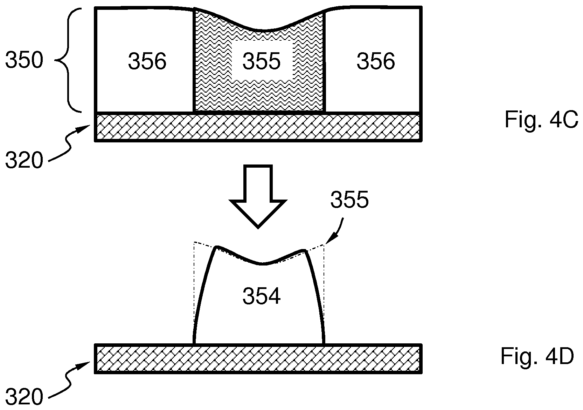

Portions of the resist layer soluble to a developer are removed during development. The removal of these portions may cause deformation in the remaining portions of the resist layer that is in addition or alternatively to deformation in the resist layer 350 as described with respect to Fig. 3. Fig. 4A, Fig. 4B, Fig. 4C and Fig. 4D schematically show such exemplary additional deformation. Fig. 4A shows the exposed resist layer 350 of Fig. 3 (with the optional deformation shown in Fig. 3C) with the portion 355 that received sufficiently high dose during the exposure and thus is soluble to a positive tone developer and portions 356 that did not receive sufficiently high dose and thus is insoluble to the positive tone developer. Fig. 4B shows that, during development, the portion 355 is dissolved and the portions 356 remain. As part of such development or during a period thereafter, portions 356 can deform into portions 357. This can occur during the removal of the portion 355 and/or for a period after development is completed. The dotted lines represent the contour of the portions 356. In the example, the portions 356 contract and become the portions 357. Fig. 4C shows the exposed resist layer 350 of Fig. 3 (with the optional deformation shown in Fig. 3C) with the portion 355 that received sufficiently high dose during the exposure and thus is insoluble to a negative tone developer and portions 356 that did not receive sufficiently high dose and thus is soluble to the negative tone developer. Fig. 4D shows that, during development, the portion 355 remains and the portions 356 are dissolved. As part of such development or during a period thereafter, portion 355 can deform into portion 354. This can occur during the removal of the portions 356 and/or for a period after development is completed. The dotted lines represent the contour of the portion 355. In the example, the portion 355 contracts and becomes the portion 354.

In an embodiment, there is provided a method to reduce resist model errors in predicting the contour of the resist layer. The method may improve accuracy of predicting the resist contours, especially for focus dependent features, by incorporating a change (i.e., difference) in aerial images over the resist layer thickness as an additional variable in the resist model.

Typical resist models (e.g. Tachyon resist model) include averaging the aerial images over the resist thickness or selecting an aerial image at a suitable height within the resist. Such an approach leads to an inaccurate prediction of features that have sub-resolution assist features (SRAFs) disposed in close proximity. Accordingly, in what follows is described by one embodiment, a variable referred to herein as vertical intensity range (VIR) at an edge feature, and defined as a measure of change in aerial image through resist thickness. The VIR is computed as follows:

$$\text{VIR}\,(x, y) = \text{AI}\,(x, y, \text{AI}_{\text{location}} = 15\ \text{nm}) - \text{AI}\,(x, y, \text{AI}_{\text{location}} = 75\ \text{nm}) \qquad (1)$$

wherein, x and y correspond to the coordinates within a layer of the resist and Allocation corresponds to a depth within the resist thickness. Note that the depth can be measured with respect to a top surface of the resist layer.

In an embodiment, changes in aerial image over the thickness alter the shape of the resist side wall, which in turn results in changes in the SEM waveform. For line space patterns, the variation in the VIR is largest for patterns with SRAF's that are out of focus and disposed in close proximity of the main feature. Moreover, the changes in aerial image through the resist thickness are correlated to a bias in the aerial image model which can be attributed to a metrology effect in critical dimension scanning electron microscope (CDSEM).

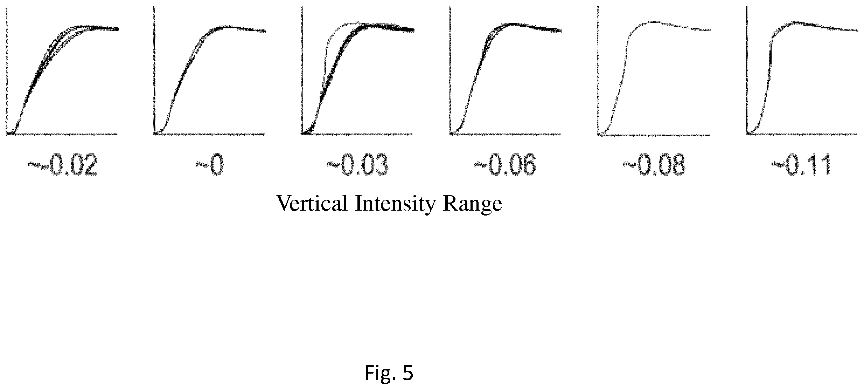

In an embodiment, a slope of the aerial image and the VIR affect the shape of the resist. The slope of the aerial image intensity as a function of position measures a steepness of the image in transitioning from bright to dark. A normalized slope (referred to herein as an image log slope (ILS)) of the aerial image is obtained by dividing the slope by the intensity of the image. Fig. 5.illustrates exemplary graphs depicting effect of vertical intensity range of feature shape for features having similar image log slope. Specifically, Fig. 5 depicts how a profile of a sidewall of the resist layer changes with varying VIR.

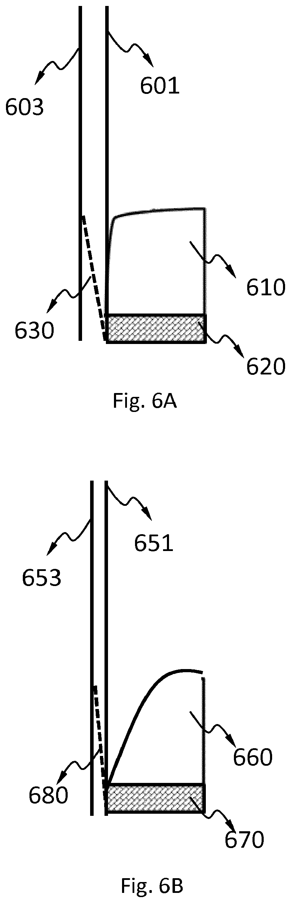

Figs. 6A and 6B, schematically illustrate the effect of the vertical intensity range on a feature shape. Fig. 6A depicts a scenario of having a large positive VIR between a top surface and a bottom surface of the resist thickness. Lines 601 and 603 represent respectively, the points with the same aerial image intensity at the bottom of the resist layer and at the top of the resist layer. It must be appreciated that when the VIR has a large positive value, (i.e., difference between aerial image intensities between the top layer and bottom layer of the resist is large), an iso-intensity curve 630 is substantially overhanging. This results in a vertical resist shape 610 formed on a substrate 620.

In contrast, Fig. 6B depicts a scenario of having a small positive VIR between the top surface and the bottom surface of the resist thickness. Lines 651 and 653 represent the points with the same aerial image intensity at the bottom of the resist layer and at the top of the resist layer, respectively. When the VIR between the top surface and the bottom surface of the resist thickness is small (i.e., difference between aerial image intensities between the top layer and bottom layer of the resist is small), the iso-intensity curve 680 is substantially vertical. In such a case, the resist 660 that is formed on the substrate 670 has a significant side wall. Thus, in order to accurately predict the shape of the resist, the VIR parameter is incorporated within the resist model as described below.

By one embodiment, the VIR is incorporated as an additional parameter in the resist model to reduce resist prediction errors and improve model accuracy for focus-sensitive patterns. For a resist model (e.g., Tachyon diffusion and development resist model) defined generically by a parameter R, the model is updated as follows:

$$R \rightarrow R + c.\text{VIR} * \text{VIR} \qquad (2)$$

where c.VIR is a fitting parameter associated with the vertical intensity range whose value can be obtained by calibrating the resist model.

As stated previously with reference to equation (1), VIR is computed as a difference between a first intensity of a first aerial image at a first location within the resist and a second intensity of a second aerial image at a second location within the resist layer. In a particular embodiment, the first location is 15 nm beneath the top surface of the resist layer and the second location is 75 nm beneath the top surface of the resist layer. However, it must be appreciated that the above values of 15 nm and 75 nm are particular examples and are not intended to limit the scope of the present disclosure. Specifically, the first location may be selected from a top-third portion of the resist layer and the second location may be selected from a bottom-third portion of the resist layer. Note that the first location (as well as the second location) is in a plane within the resist layer substantially/essentially parallel to the top surface of the resist layer.

Additionally, in an embodiment, the first location can be a location corresponding to a first weighted average intensity of aerial images computed in a first portion of the resist layer, and the second location can be a location corresponding to a second weighted average intensity of aerial images computed in a second portion of the resist layer. For example, the first and second weighted average intensities can be computed based on a Gaussian distribution that is centered at 15nm, and having a standard deviation of 2.2.nm. The first portion can be a top portion of the resist layer having a first height, and the second portion is a bottom portion of the resist layer having a second height, wherein the first height and the second height is 15% of a height of the resist layer. Alternatively, the first height and the second height can be 10% of a height of the resist layer. In one embodiment, the first height and the second height can be in the range 10% to 15% of the height of the resist layer. Note that in the above embodiments, height of the resist layer corresponds to a thickness of the resist layer.

Further, in an embodiment, instead of performing a simulation of the resist layer to obtain a value of a parameter for a resist layer feature based on a difference between the first and second intensities, the model can incorporate a difference between a resist model result for the first intensity and a resist model result for the second intensity to accurately predict the shape of the resist layer.

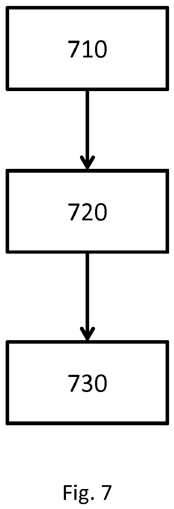

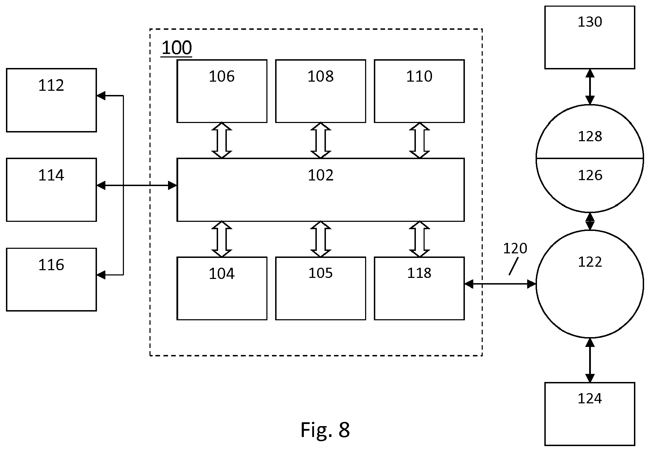

Fig. 7 depicts an exemplary flowchart illustrating steps performed to improve resist model errors. The method as outlined in Fig. 7 may be executed by a processor (described next with reference to Fig. 8) included in the lithography system of the present disclosure.

The process commences in step 710, wherein a first intensity of a first aerial image is computed. The process thereafter proceeds to step 720, wherein a second intensity of a second aerial image is computed. Note that the first aerial image corresponds to a first location within a resist layer and the second aerial image corresponds to a second location within the resist layer.

Further, the process in step 730 performs a computer simulation of the resist layer to obtain a value of a parameter for a resist layer feature based on a difference between the first and second intensities. It must be appreciated that at step 730, the process may alternatively compute a difference between a resist model result for the first intensity and a resist model result for the second intensity. Upon performing the computation in step 730, the process as outlined in Fig. 7 terminates.

Fig. 8 is a block diagram that illustrates a computer system 100 which perform one or more aspects of the methods and flows disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of a process described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 also preferably includes a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide for a process as described herein, for example. The received code may be executed by processor 104 as it is received, and/or stored in storage device 110, or other non-volatile storage for later execution. In this manner, computer system 100 may obtain application code in the form of a carrier wave.

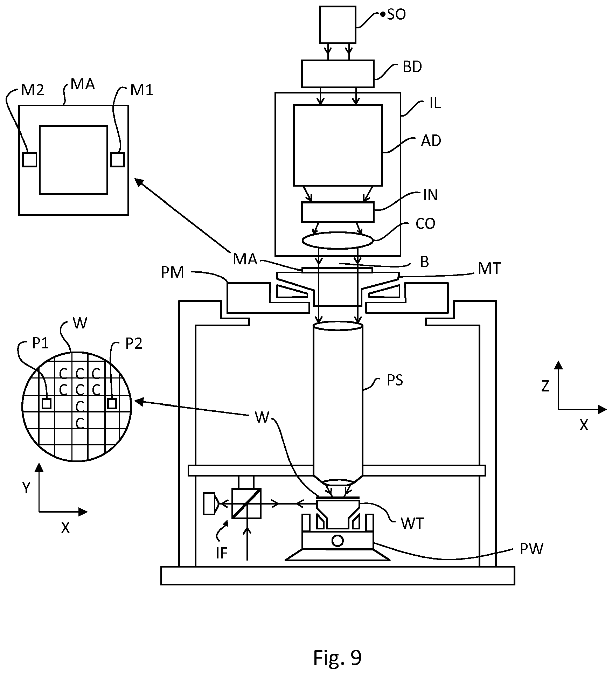

Fig. 9 schematically depicts an exemplary lithographic projection apparatus for use with the methods described herein. The apparatus comprises:

- an illumination system IL, to condition a beam B of radiation. In this particular case, the illumination system also comprises a radiation source SO;

  - a first object table (e.g., mask table) MT provided with a patterning device holder to hold a patterning device MA (e.g., a reticle), and connected to a first positioner to accurately position the patterning device with respect to item PS;
  - a second object table (substrate table) WT provided with a substrate holder to hold a substrate W (e.g., a resist-coated silicon wafer), and connected to a second positioner to accurately position the substrate with respect to item PS;
  - a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive mask). However, in general, it may also be of a reflective type, for example (with a reflective mask). Alternatively, the apparatus may employ another kind of patterning device as an alternative to the use of a classic mask; examples include a programmable mirror array or LCD matrix.

The source SO (e.g., a mercury lamp or excimer laser) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as $\alpha$-outer and $\sigma$-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Fig. 9 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or $F_2$ lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 9. However, in the case of a wafer stepper (as opposed to a step-and-scan tool) the patterning device table MT may just be connected to a short stroke actuator, or may be fixed.

The depicted tool can be used in two different modes:

- In step mode, the patterning device table MT is kept essentially stationary, and an entire patterning device image is projected in one go (i.e., a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

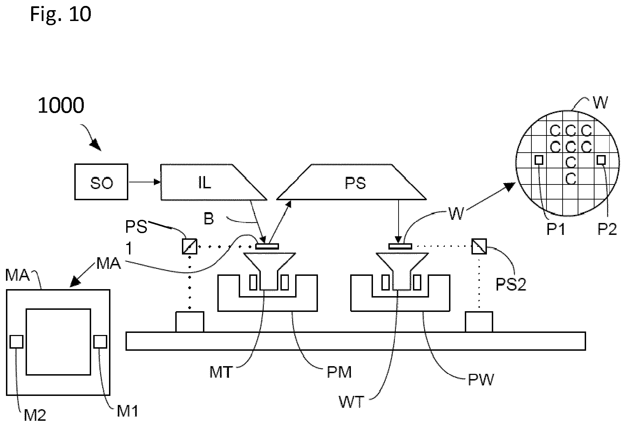

Fig. 10 schematically depicts another exemplary lithographic projection apparatus 1000 that can be used for the methods described herein.

The lithographic projection apparatus 1000 includes:

- a source collector module SO
- an illumination system (illuminator) IL configured to condition a radiation beam B (e.g. EUV radiation).
- a support structure (e.g. a mask table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus 1000 is of a reflective type (e.g. employing a reflective mask). It is to be noted that because most materials are absorptive within the EUV wavelength range, the mask may have multilayer reflectors comprising, for example, a multi-stack of molybdenum and silicon. In one example, the multi-stack reflector has a 40 layer pairs of molybdenum and silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Referring to Fig. 10, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Fig. 10, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases the source may be an integral part of the source collector module, for example when the source is a discharge produced plasma EUV generator, often termed as a DPP source.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus 1000 could be used in at least one of the following modes:

1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.

3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to mask less lithography that utilizes programmable patterning device, such as a programmable mirror array of a type as referred to above.

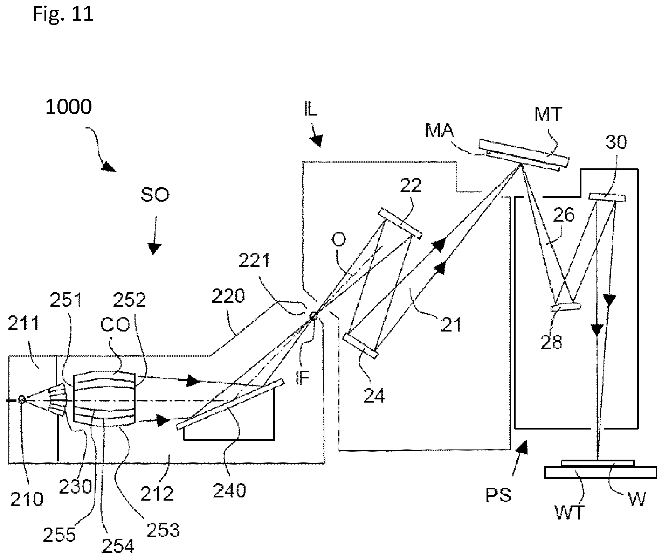

Fig. 11 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. A EUV radiation emitting plasma 210 may be formed by a discharge produced plasma source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap), which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the Figures, for example there may be 1- 6 additional reflective elements present in the projection system PS than shown in Fig. 11.

Collector optic CO, as illustrated in Fig. 11, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type is preferably used in combination with a discharge produced plasma source, often called a DPP source.

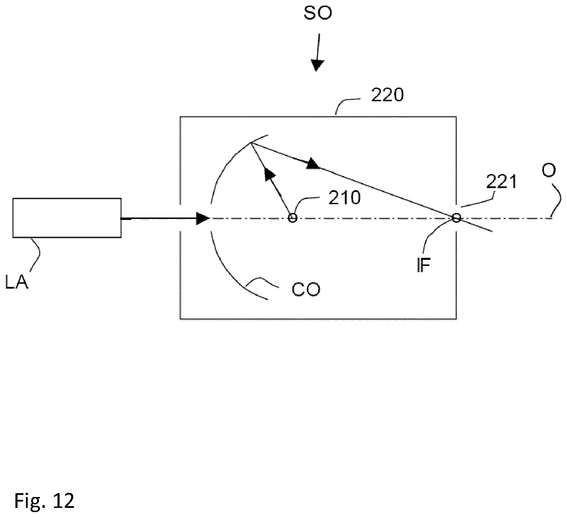

Alternatively, the source collector module SO may be part of an LPP radiation system as shown in Fig. 12. A laser LA is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

Although specific reference may be made in this text to the manufacture of devices such as ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

It is noted that the terms "mask", "reticle", and "patterning device" are utilized interchangeably herein. Also, a person skilled in the art will recognize that, especially in the context of lithography simulation/optimization, the term "mask"/"patterning device" and "design layout" can be used interchangeably, as in lithography simulation/optimization, a physical patterning device is not necessarily used but a design layout can be used to represent a physical patterning device.

In the present document, the terms "radiation" and "beam" are used to encompass all types of electromagnetic radiation, including ultraviolet radiation (e.g. with a wavelength of 365, 248, 193, 157 or 126 nm) and extreme ultra-violet radiation (EUV), e.g. having a wavelength in the range 5-20 nm).

The terms "optimizing" and "optimization" as used herein mean adjusting a lithographic projection apparatus and/or a patterning process such that results and/or processes of the patterning process (such as lithography) have a more desirable characteristic, such as higher accuracy of projection of design layouts on a substrate, a larger process window, etc. The terms "optimizing" and "optimization" do not necessarily require that results and/or processes of lithography have the most desirable characteristics, such as highest accuracy of projection of design layouts on a substrate, largest process window, etc.

The patterning device referred to above comprises or can form design layouts. The design layouts can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between circuit devices (such as gates, capacitors, etc.) or interconnect lines, so as to ensure that the circuit devices or lines do not interact with one another in an undesirable way. The design rule limitations are typically referred to as "critical dimensions" (CD). A critical dimension of a circuit can be defined as the smallest width of a line or hole or the smallest space between two lines or two holes. Thus, the CD determines the overall size and density of the designed circuit. Of course, one of the goals in integrated circuit fabrication is to faithfully reproduce the original circuit design on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include a programmable mirror array and/or a programmable LCD array.

The concepts disclosed herein may simulate or mathematically model any patterning process, and may be especially useful with imaging technologies capable of producing increasingly shorter wavelengths. Examples of such imaging technologies already in use include EUV (extreme ultra violet), DUV lithography that is capable of producing a 193 nm wavelength with the use of an ArF laser and/or a 157 nm wavelength with the use of a fluorine laser. Moreover, EUV lithography is capable of producing wavelengths within a range of about 5 nm to about 20 nm by using, e.g., a synchrotron or by hitting a material (either solid or a plasma) with high energy electrons in order to produce photons within this range.

While the concepts disclosed herein may be used for patterning processes involving imaging on a substrate such as a silicon wafer, it shall be understood that the disclosed concepts may be used with any type of lithographic systems, e.g., those used for imaging on substrates other than silicon wafers.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

The embodiments may further be described using the following clauses:

1. A method comprising:

computing a first intensity of a first aerial image and a second intensity of a second aerial image, the first aerial image corresponding to a first location within a resist layer and the second aerial image corresponding to a second location within the resist layer; and

performing, by a hardware computer system using a resist model, a computer simulation of the resist layer to obtain a value of a parameter for a resist layer feature based on a difference between the first and second intensities or on a difference between a resist model result for the first intensity and a resist model result for the second intensity.

2. The method of clause 1, further comprising:

obtaining the value of the parameter for the resist layer based on the difference between the first and second intensities.

3. The method of clause 1, further comprising:

obtaining the value of the parameter based on the difference between the resist model result for the first intensity and the resist model result for the second intensity.

4. The method of clause 1, wherein the first location is at a first depth within the resist layer and the second location is at a second depth within the resist layer, different from the first depth, the first depth and the second depth being measured with respect to a top surface of the resist layer.

5. The method according to any of clauses 1 to 4, wherein the first location is in a top-third portion of the resist layer and the second location is in a bottom-third portion of the resist layer.

6. The method of anyone of clause 1 or clause 5, wherein the first depth is 15 nanometers below the top surface of the resist layer and the second depth is 75 nanometers below the top surface of the resist layer.

7. The method of clauses 1 to 6, wherein the resist model is updated with a fitting parameter associated with the computed difference.

8. The method of clauses 1 to 6, further comprising:

calibrating the resist model to obtain a value of a fitting parameter.

9. The method of any of clauses 1 to 8, wherein the resist model comprises a product of a fitting parameter and the difference between the first and second intensities.

10. The method according to any of clauses 1 to 9, wherein the first location is a location corresponding to a first weighted average intensity of aerial images computed in a first portion of the resist layer, and the second location is a location corresponding to a second weighted average intensity of aerial images computed in a second portion of the resist layer.

11. The method of clause 10, wherein the first portion is a top portion of the resist layer having a first height, and the second portion is a bottom portion of the resist layer having a second height.

12. The method of clause 11, wherein the first height and the second height are 15% of a height of the resist layer.

13. The method of clause 11, wherein the first height and the second height are 10% of a height of the resist layer.

14. The method of clause 1, wherein the resist feature comprises a developed resist wall.

15. The method of clause 1, further comprising:

imaging a substrate having a resist layer thereon based on the obtained value of the parameter.

16. A device, comprising:

a processor configured to

compute a first intensity of a first aerial image and a second intensity of a second aerial image, the first aerial image corresponding to a first location within a resist layer and the second aerial image corresponding to a second location within the resist layer; and

perform a computer simulation of the resist layer to obtain a value of a parameter for a resist layer feature based on a difference between the first and second intensities or on a difference between a resist model result for the first intensity and a resist model result for the second intensity.

17. The device of clause 16, wherein the processor is configured to obtain the value of the parameter for the resist layer based on the difference between the first and second intensities.

18. The device of clause 16, wherein the processor is configured to obtain the value of the parameter based on the difference between the resist model result for the first intensity and the resist model result for the second intensity.

19. The device of clause 16, wherein the first location is at a first depth within the resist layer and the second location is at a second depth within the resist layer, the first depth and the second depth being measured with respect to a top surface of the resist layer.

20. The device according to clauses 16 to 19, wherein the first location is in a top-third portion of the resist layer and the second location is in a bottom-third portion of the resist layer.

21. The device according to anyone of clauses 16 or 20, wherein the first depth is 15 nanometers below the top surface of the resist layer and the second depth is 75 nanometers below the top surface of the resist layer.

22. The device of clauses 16 to 21, wherein the resist model is updated with a fitting parameter associated with the computed difference.

23. The device of clauses 16 to 21, wherein the processor is configured to calibrate the resist model to obtain a value of a fitting parameter.

24. The device of clauses 16 to 23, wherein the resist model comprises a product of a fitting parameter and the difference between the first and second intensities.

25. The device according to any of clauses 16 to 24, wherein the first location is a location corresponding to a first weighted average intensity of aerial images computed in a first portion of the resist layer, and the second location is a location corresponding to a second weighted average intensity of aerial images computed in a second portion of the resist layer.

26. The device according to clause 25, wherein the first portion is a top portion of the resist layer having a first height, and the second portion is a bottom portion of the resist layer having a second height.

27. The device according to clause 26, wherein the first height and the second height are 15% of a height of the resist layer.

28. The device according to clause 26, wherein the first height and the second height are 10% of a height of the resist layer.

29. The device according to clause 16, wherein the resist feature comprises a developed resist wall.

30. The device of clause 16, wherein the parameter comprises a location in a plane essentially parallel to the resist layer.

31. A non-transitory computer program product comprising machine-readable instructions for causing a processor to cause performance of the method of any of clauses 1 to 15.

32. A system, comprising
a hardware processor; and
the non-transitory computer program product of clause 31.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the spirit of the present disclosures. The accompanying claims and their equivalents are intended to cover such forms or modifications as would fall within the scope and spirit of the present disclosures.

**Claims**

1. A method comprising:

   computing a first intensity of a first aerial image and a second intensity of a second aerial image, the first aerial image corresponding to a first location within a resist layer and the second aerial image corresponding to a second location within the resist layer; and

   performing, by a hardware computer system using a resist model, a computer simulation of the resist layer to obtain a value of a parameter for a resist layer feature based on a difference between the first and second intensities or on a difference between a resist model result for the first intensity and a resist model result for the second intensity.

2. The method of claim 1, further comprising:

   obtaining the value of the parameter for the resist layer based on the difference between the first and second intensities.

3. The method of claim 1, further comprising:

   obtaining the value of the parameter based on the difference between the resist model result for the first intensity and the resist model result for the second intensity.

4. The method of claim 1, wherein the first location is at a first depth within the resist layer and the second location is at a second depth within the resist layer, different from the first depth, the first depth and the second depth being measured with respect to a top surface of the resist layer.

5. The method of claim 1, wherein the first location is in a top-third portion of the resist layer and the second location is in a bottom-third portion of the resist layer.

6. The method of claim 1, wherein the resist model is updated with a fitting parameter associated with the computed difference.

7. The method of claim 1, further comprising:

   calibrating the resist model to obtain a value of a fitting parameter.

8. The method of claim 1, wherein the resist model comprises a product of a fitting parameter and the difference between the first and second intensities.

9. The method of claim 1, wherein the first location is a location corresponding to a first weighted average intensity of aerial images computed in a first portion of the resist layer, and the second location is a location corresponding to a second weighted average intensity of aerial images computed in a second portion of the resist layer.

10. The method of claim 9, wherein the first portion is a top portion of the resist layer having a first height, and the second portion is a bottom portion of the resist layer having a second height.

11. The method of claim 10, wherein the first height and the second height are 15% of a height of the resist layer, or wherein the first height and the second height are 10% of a height of the resist layer.

12. The method of claim 1, wherein the resist feature comprises a developed resist wall.

13. The method of claim 1, further comprising:

imaging a substrate having a resist layer thereon based on the obtained value of the parameter.

14. A non-transitory computer program product comprising machine-readable instructions for causing a processor to cause performance of the method of any of claims 1-13.

15. A system, comprising
a hardware processor; and
the non-transitory computer program product of claim 14.

10A

12A

14A

16Aa, 16Ab

18A

Fig. 1

20A

16Ac

22A

Fig. 2

320

310

Fig. 3A

330

340

320

310

Fig. 3B

320

350

Fig. 3C

320

356    355    356

Fig. 3D

350 { 356    355    356

320

Fig. 4A

380

356    356

350 { 357    370    357

320

Fig. 4B

350 356 355 356

320

Fig. 4C

355

354

320

Fig. 4D

~-0.02     ~0     ~0.03     ~0.06     ~0.08     ~0.11

Vertical Intensity Range

Fig. 5

603

601

630

610

620

Fig. 6A

653

651

680

660

670

Fig. 6B

```
┌─────────────┐
│             │
│     710     │
│             │
└──────┬──────┘
       │
       ▼
┌─────────────┐
│             │
│     720     │
│             │
└──────┬──────┘
       │
       ▼
┌─────────────┐
│             │
│     730     │
│             │
└─────────────┘
```

Fig. 7

Fig. 8

Fig. 9

Fig. 10

Fig. 11

Fig. 12

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/218160 A1 (HUANG JENSHENG [US] ET AL) 26 August 2010 (2010-08-26) | 1,3-7, 9-15 | INV. G03F7/20 |
| A | * paragraphs [0047] - [0061], [0071]; figures 3,4,8 * | 2,8 | |
| X | US 2016/231654 A1 (HSU DUAN-FU STEPHEN [US] ET AL) 11 August 2016 (2016-08-11) * paragraphs [0065], [0074]; figure 8 * | 1,3-7, 9-15 | |
| X | CHEN AO ET AL: "Resist profile aware source mask optimization", VISUAL COMMUNICATIONS AND IMAGE PROCESSING; 20-1-2004 - 20-1-2004; SAN JOSE,, vol. 9053, 28 March 2014 (2014-03-28), pages 90530X-90530X, XP060031209, DOI: 10.1117/12.2046252 ISBN: 978-1-62841-730-2 * section 3.1; figures 2,5 * | 1,3-7, 9-15 | |

TECHNICAL FIELDS SEARCHED (IPC)

G03F

The present search report has been drawn up for all claims

| Place of search | Date of completion of the search | Examiner |
|---|---|---|
| Munich | 5 October 2018 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**EP 3 531 206 A1**

## ANNEX TO THE EUROPEAN SEARCH REPORT
## ON EUROPEAN PATENT APPLICATION NO.

EP 18 15 8448

05-10-2018

| Patent document cited in search report | | Publication date | Patent family member(s) | | Publication date |
|---|---|---|---|---|---|
| US 2010218160 | A1 | 26-08-2010 | CN | 101675389 A | 17-03-2010 |
| | | | TW | 200844781 A | 16-11-2008 |
| | | | US | 2007282574 A1 | 06-12-2007 |
| | | | US | 2010218160 A1 | 26-08-2010 |
| | | | WO | 2008136873 A1 | 13-11-2008 |
| US 2016231654 | A1 | 11-08-2016 | KR | 20160062141 A | 01-06-2016 |
| | | | SG | 11201602179W A | 28-04-2016 |
| | | | TW | 201527894 A | 16-07-2015 |
| | | | US | 2016231654 A1 | 11-08-2016 |
| | | | WO | 2015049099 A1 | 09-04-2015 |

EPO FORM P0459

**EP 3 531 206 A1**

**Patent documents cited in the description**

- US 7587704 B
- US 8200468 B